(19) Europäisches Patentamt / European Patent Office / Office européen des brevets

(11) **EP 2 693 630 A1**

(12) **EUROPÄISCHE PATENTANMELDUNG**

(43) Veröffentlichungstag:
**05.02.2014 Patentblatt 2014/06**

(21) Anmeldenummer: **12005574.4**

(22) Anmeldetag: **31.07.2012**

(51) Int Cl.:
*H03C 1/00* (2006.01)    *H03C 3/00* (2006.01)
*H03D 9/00* (2006.01)    *G01J 3/00* (2006.01)
*G01R 31/00* (2006.01)    *G02F 2/00* (2006.01)

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(71) Anmelder: **QIAGEN Lake Constance GmbH**
**78333 Stockach (DE)**

(72) Erfinder:
• **Drexler, Josef**
**78333 Stockach (DE)**
• **Feuerbacher, Elmar Christian**
**78333 Stockach (DE)**
• **Fornezza, Daniele**
**78333 Stockach (DE)**

(74) Vertreter: **Hössle Patentanwälte Partnerschaft**
**Postfach 10 23 38**
**70019 Stuttgart (DE)**

(54) **Verfahren zum Bereitstellen modulierter Anregungssignale**

(57)     Es werden ein Verfahren zum Bereitstellen modulierter Anregungssignale und eine elektronische Einheit zur Durchführung des Verfahrens vorgestellt. Bei dem Verfahren werden den Anregungssignalen Modulationssignale zugeordnet, deren Frequenzen unterschiedlich sind und keine der Frequenzen ein ganzzahliges Vielfaches einer der anderen Frequenzen ist, und bei dem mit jedem der Modulationssignale jeweils eine Quelle angeregt wird.

Fig. 2

EP 2 693 630 A1

**Beschreibung**

Die Erfindung betrifft ein Verfahren zum Bereitstellen einer Anzahl von modulierten Anregungssignalen sowie eine elektronische Einheit zur Durchführung des Verfahrens. Mit dem vorgestellten Verfahren kann insbesondere ein sogenanntes Lock-in-Verfahren durchgeführt werden, mit dem eine Anzahl von Messsignalen gleichzeitig ausgewertet werden kann.

Als Modulation wird ein Verfahren bezeichnet, bei dem ein zu übertragendes Nutzsignal ein sogenanntes Träger- bzw. Modulationssignal ändert bzw. moduliert. Somit kann bspw. eine hochfrequente Übertragung eines niederfrequenten Nutzsignals ermöglicht werden. Das modulierte Signal wird auf Empfängerseite wieder demoduliert. Auf diese Weise kann eine Anpassung an physikalische Eigenschaften des Übertragungskanals vorgenommen werden.

Somit ist die Modulation gegenüber einer direkten Übertragung des Nutzsignals vorteilhaft. Zu beachten ist, dass sowohl analoge als auch digitale Signale übertragen werden können. Weiterhin ist zu berücksichtigen, dass das Modulationsverfahren unabhängig von der Art des Nutzsignals analog oder digital sein kann.

Im Bereich der Messtechnik stellt es sich als problematisch dar, wenn mehrere Signale, die über eine entsprechende Anzahl an Kanälen erfasst und bewertet werden sollen, aus einer rauschbehafteten Messung mit einem minimalen Übersprechen zwischen den Kanälen extrahiert werden sollen. Ein bekanntes Verfahren zur Signalextraktion ist das sogenannte Lock-in-Verfahren mittels einer sogenannten Lock-in-Einheit bzw. eines Lock-in-Verstärkers.

Lock-in-Verstärker, die auch als phasenempfindliche Gleichrichter bezeichnet werden, sind Verstärker, die zur Messung eines elektrischen Wechselsignals, insbesondere eines schwachen elektrischen Wechselsignals, eingesetzt werden. Hierzu wird das elektrische Wechselsignal mit einem Modulationssignal moduliert, dessen Frequenz und Phase bekannt sind. Dieses modulierte Messsignal und das Modulationssignal werden miteinander multipliziert und anschließend in einem Tiefpass integriert.

Zu beachten ist, dass die Kreuzkorrelation der beiden Signale bei unendlich langer Integrationszeit als Ergebnis der Multiplikation für Signale unterschiedlicher Frequenz gleich null ist. Ist daher die Frequenz des modulierten Messsignals und des Modulationssignals unterschiedlich, liefert der Lock-in-Verstärker kein Ausgangssignal. Nur für gleiche Frequenzen ergibt sich ein Wert ungleich null und der Lock-in-Verstärker liefert ein endliches Ausgangssignal. Daher kann durch Wahl der passenden Frequenz des Modulationssignals die entsprechende Komponente im Messsignal extrahiert werden.

Ein üblicher Lock-in-Verstärker erfordert jedoch eine lange Integrationszeit, um mehrere Signale einer ähnlichen Modulationsfrequenz zu trennen oder erfordert, dass jedes Signal mit einer Frequenz moduliert ist, die verschieden von allen anderen Frequenzen, die zu erfassen sind, ist. Somit stellt sich die Extraktion der Signale als problematisch dar, insbesondere wenn eine kurze Integrationszeit eingehalten werden soll.

Lock-in-Verstärker mit einer einzelnen Modulation oder einem Modulationssignal, wie diese vorstehend erläutert sind, sind bekannt. Zum Messen mehrerer unabhängiger Signale mit verschiedenen Modulationen und damit für eine notwendige Mehrkanalfähigkeit sind bislang mehrere Lock-in-Verstärker erforderlich. Dies bedingt jedoch lange Integrationszeiten oder sehr unterschiedliche Modulationsfrequenzen, um die einzelnen Signale deutlich zu trennen.

Vor diesem Hintergrund werden ein Verfahren nach Patentanspruch 1 und eine elektronische Einheit mit den Merkmalen des Patentanspruchs 10 vorgestellt. Ausführungsformen ergeben sich aus den abhängigen Ansprüchen und der Beschreibung.

Das vorgestellte Verfahren dient zum Bereitstellen einer Anzahl von modulierten Anregungssignalen, bei dem jedem der Anregungssignale ein periodisches Modulationssignal zugeordnet wird, wobei die Frequenzen der Modulationssignale unterschiedlich sind und keine der Frequenzen ein ganzzahliges Vielfaches einer der anderen Frequenzen ist, und bei dem mit jedem der Modulationssignale jeweils eine Quelle angeregt wird, so dass jede Quelle ein mit dem zugeordneten Modulationssignal moduliertes Anregungssignal ausgibt.

Es kann jeweils eine Amplitudenmodulation oder eine Frequenzmodulation vorgenommen werden.

In Ausgestaltung sind die Modulationssignale zueinander synchronisiert. Dies wird bspw. dadurch erreicht, dass die Modulationssignale auf den Ausgang eines Frequenzgenerators durch Einsatz einer Anzahl von Frequenzteilern zurückgehen. In einer Ausführung des Verfahrens wird mit den Modulationssignalen jeweils eine Lichtquelle, bspw. Laserlichtquellen, angeregt. Es können aber auch andere Quellen, wie bspw. Tonquellen, eingesetzt werden. Dies kann bei akustischen Messverfahren vorgesehen sein.

Es bietet sich an, die Anregungssignale zu einem Anregungsstrahl zu kombinieren. Dieser Anregungsstrahl wird dann üblicherweise zu einer Mess- bzw. Detektionseinrichtung übermittelt.

Das vorstehend beschriebene Verfahren betrifft eine Modulation von Signalen. Werden zu dieser Modulation zusätzlich eine Detektion und eine Demodulation durchgeführt, so betrifft das gesamte Verfahren ein sogenanntes Lock-in-Verfahren. In diesem Fall wird bei der Demodulation auf Informationen der Modulation, bspw. hinsichtlich Integrationszeit und Modulationssignalen, zurückgegriffen.

Es wird weiterhin eine elektronische Einheit zum Modulieren einer Anzahl an Signalen vorgestellt, die insbesondere zur Durchführung des vorstehend beschriebenen Verfahrens ausgelegt ist. Diese Einheit umfasst eine Anordnung zum Bereitstellen einer Anzahl von Modulationssignalen und eine entsprechende Anzahl von Quellen. Bei den Modulationssignalen werden die Frequenzen so gewählt, dass diese unterschiedlich sind und keine der Frequenzen ein ganzzahliges Vielfaches einer der anderen Frequenzen ist.

In einer Ausführung umfasst die Anordnung zum Bereitstellen einer Anzahl von Modulationssignalen einen Frequenzteiler.

Die Quellen können als Lichtquellen, bspw. als Laserlichtquellen, ausgebildet sein.

Es können weiterhin eine Einrichtung zur Demodulation und eine Einrichtung zur Detektion, die bspw. einen Detektorkopf umfasst, vorgesehen sein. Auf diese Weise ist ein sogenanntes Lock-in-Verfahren durchführbar.

Das eingangs beschriebene Verfahren ermöglicht die Bereitstellung einer Anzahl von Anregungssignalen, die in einer Messanordnung verwendet werden können. Die besondere Art des durchgeführten Verfahrens gestattet es, Messsignale, die auf den bereitgestellten Anregungssignale beruhen, zu trennen bzw. zu separieren und getrennt auszuwerten, ohne dass es zu einem Übersprechen zwischen Kanälen der Messsignale kommt.

Weiterhin ist von Bedeutung, dass die Frequenzen der Modulationssignale so gewählt werden können, dass diese nicht weit auseinander liegen müssen, was hinsichtlich der für die Übertragung erforderlichen Bandbreite von Vorteil ist.

Bei dem vorgestellten Verfahren ist somit in Ausgestaltung vorgesehen, die Modulation für jeden Kanal zu synchronisieren, um die Signale der einzelnen Kanäle mit einer kurzen Integrationszeit zu trennen. Durch Synchronisieren der Modulationen kann die Integrationszeit sehr kurz gewählt werden, bspw. entsprechend einiger weniger Modulationsperioden. Dabei wird gleichzeitig eine optimale Kanaltrennung erreicht und ein wirksames Verhindern eines Übersprechens zwischen den einzelnen Kanälen ermöglicht.

In Ausgestaltung ist eine phasenkohärente Modulation der mehreren Kanäle gekoppelt mit einer phasenkohärenten Analog-/Digitalwandlung und einer Datenerfassung vorgesehen.

Weitere Vorteile und Ausgestaltungen der Erfindung ergeben sich aus der Beschreibung und den beiliegenden Zeichnungen. Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Figur 1 zeigt eine Ausführungsform der beschriebenen Einheit in einem schematischen Blockschaltbild.

Figur 2 zeigt eine Ausführung des vorgestellten Verfahrens.

Die Erfindung ist anhand von Ausführungsformen in der Zeichnung schematisch dargestellt und wird nachfolgend unter Bezugnahme auf die Zeichnung ausführlich beschrieben.

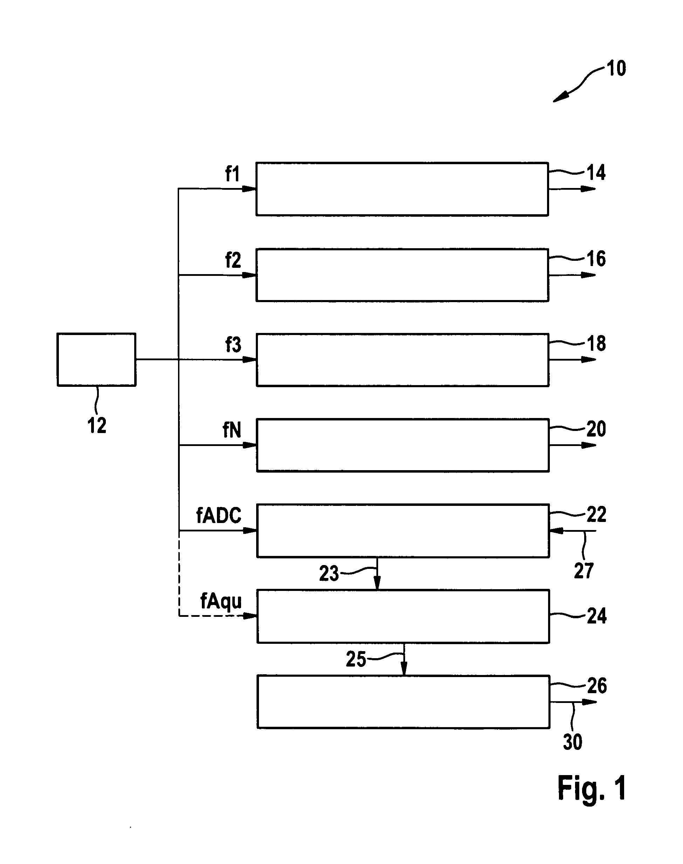

Figur 1 zeigt in einer schematischen Darstellung eine Ausführung der vorgestellten elektronischen Einheit 10, die umfasst:

ein Zeitgeber- bzw. Timerelement 12, das mehrere phasensynchrone Taktpulse mit spezifizierten Frequenzen erzeugt,

N Frequenzgeneratoren, von denen hier nur ein Frequenzgenerator 1 14, ein Frequenzgenerator 2 16, ein Frequenzgenerator 3 18 und ein Frequenzgenerator N 20 dargestellt sind, wobei N die Anzahl der Kanäle ist, die ein sinusförmiges Modulationsausgabesignal aus dem Frequenzsignal des Timerelements erzeugt,

einen Analog-/Digitalwandler (ADC) 22, um die analogen Eingabesignale mit einer Abtastfrequenz abzutasten, die durch das Timerelement 12 getaktet sind, wobei der ADC 22 ein digitalisiertes Signal 23 ausgibt, das auf einem analogen Eingabesignal 27 beruht,

eine Datenerfassungseinrichtung 24, welche die Ausgabe des ADC 22 als eine Zeitreihe aufzeichnet, wobei die Datenerfassung optional durch das Timerelement 12 getriggert ist, und wobei diese eine Zeitreihe 25 ausgibt,

einen Demodulationsalgorithmus 26, der die Amplitude und Phase der Signale der einzelnen Kanäle aus der Zeitreihe extrahiert und in einer Ausführung ein Ergebnis 30 für einen der Kanäle 1 bis N ausgibt. In diesem Fall sind N Demodulationsalgorithmen vorgesehen. Es kann jedoch auch nur ein Demodulationsalgorithmus vorgesehen sein, der Ergebnisse für alle Kanäle liefert.

Als Timerelement 12 kann irgendein Timer verwendet werden, der geeignet ist, die erforderten phasensynchronen Taktpulse zu erzeugen. Beispielsweise kann ein programmierbares Zählerfeld (PCA: Programable Counter Array) verwendet werden, das programmiert ist, um die erforderten Taktimpulse zu erzeugen. Dieses hat 6 PCA Ausgaben und erlaubt somit bis zu vier Signalkanäle, von denen hier drei verwendet werden. Für jede Ausgabe ist ein Integer-Frequenzteiler gesetzt, der die Taktfrequenz des Chips (24 MHz) aufteilt, um das Ausgabesignal zu erzeugen.

Als Frequenzgeneratoren 14, 16, 18 und 20 können Sinusformgeneratoren mit einer Takteingabe und einer konfigurierbaren Phasendifferenz pro Takt verwendet werden.

Der ADC 22 muss eine sogenannte "Conversion Start" Eingabe haben, die durch das Timerelement 12 getaktet ist. Beim Empfangen eines Taktpulses startet dieser die ADC-Wandlung des analogen Eingabesignals. Wenn die Wandlung abgeschlossen ist, überträgt ein Handshake-Vorgang die digitalen Daten zu der Datenerfassungseinrichtung 24.

Die Datenerfassungseinrichtung 24 empfängt die digitalen Daten von dem ADC 22 und zeichnet diese als eine Zeitreihe auf. Die Datenerfassungseinrichtung 24 ist optional durch das Timerelement 12 getriggert, so dass jeder Erfassungsrahmen startet, wenn ein Puls von dem Timerelement 12 empfangen wird. Der optionale Trigger ermöglicht einen Betrieb mit einer bekannten und stabilen Modulationsphase in dem Erfassungsrahmen, wenn dieser Wert von Bedeutung ist.

Für jeden Rahmen, der durch die Datenerfassung empfangen wird, berechnet der Demodulationsalgorithmus die Amplitude und Phase der Fourier-Komponente entsprechend aller N Modulationskanäle. Somit entspricht ein Rahmen der Zeitreihe der Integrationszeit eines herkömmlichen Lock-in-Verstärkers.

Ein wichtiges Element des vorgestellte Verstärkers ist die phasenkohärente Modulation der mehreren Kanäle gekoppelt mit einer phasenkohärenten Analog-/Digitalwandlung und Datenerfassung. Dies bedeutet, dass jeder Datenerfassungsrahmen aus einer genauen Integerzahl von ADC-Abtastungen besteht, was einer genauen ganzen Anzahl von Frequenztaktimpulsen des Kanals entspricht und damit einer genauen ganzen Zahl von Sinuswellenperioden in jedem Rahmen für alle Kanäle.

Da alle Kanäle eine ganze Anzahl von Perioden in jedem Rahmen haben, ist die Demodulationsamplitude aller anderen Modulationsfrequenzen mathematisch gleich Null. Dies bedeutet, dass ein Übersprechen optimal verhindert wird.

Bei der praktischen Anwendung liegt ein Rauschen in dem System vor, so dass das Übersprechen nicht Null ist. Jedoch reduziert das System selbst für große Signalamplituden das Übersprechen auf dasselbe Niveau wie das Rauschniveau.

Nachfolgend ist anhand zweier Tabellen eine mögliche Umsetzung gegeben:

Tabelle 1

| Symbol | Bedeutung | Wert |
|---|---|---|
| $f_0$ | Basisfrequenz des Timers | 24 MHz |
| $k_1$ | Frequenzteiler für Kanal 1 | 12 |
| $N_1$ | Anzahl an Taktpulsen pro Periode für Kanal 1 | 64 |
| $f_1$ | Modulationsfrequenz für Kanal 1 | $f_0/k_1/N_1$ = 31,25 kHz |
| $k_2$ | | 20 |
| $N_2$ | | 64 |
| $f_2$ | | 18,75 kHz |
| $k_3$ | | 30 |
| $N_3$ | | 64 |
| $f_3$ | | 12,5 kHz |
| $k_{ADC}$ | Frequenzteiler für AD-Wandlung | 30 |
| $f_{ADC}$ | ADC-Abtastrate | $f_0/k_{ADC}$ = 800 kHz |
| $N_{Aqu}$ | Anzahl an Abtastungen pro Erfassungsrahmen | 128 |
| $f_{Aqu}$ | Frequenz des Erfassungsrahmens | $f_{ADC}/N_{Aqu}$ = 6, 25 kHz |
| T | Integrationsszeit | $1/f_{Aqu}$ = 0, 116 ms |
| $n_1$ | Anzahl an Sinuswellen pro Rahmen, Kanal 1 | 5 |
| $n_2$ | | 3 |
| $n_3$ | | 2 |

Zu Betriebsbedingungen wird nachfolgend ausgeführt:

Das optimale Verhindern eines Übersprechens beruht darauf, dass alle Kanäle eine ganzzahlige Anzahl von Perioden pro Integrationszeitintervall ($n_i$) haben, wobei keine Anzahl der Periode ein ganzzahliges Vielfaches irgendeiner anderen Periode ist. Beispielsweise ist die Kombination (2, 3, 6) keine gültige Kombination, da 6 ein ganzzahliges Vielfaches von 2 und sogar auch von 3 ist. Die Kombinationen (2, 3, 5) und (6, 10, 15) sind gültige Kombinationen.

Die minimale Integrationszeit T wird durch das kleinste gemeinsame Vielfache (kgV) der Zahlkombination bestimmt. Ein größeres kgV bedeutet eine längere Integrationszeit. Wenn eine kurze Integrationszeit für die konkrete Anwendung von Bedeutung ist, sollten die Periodenzahlen entsprechend ausgewählt werden. Bei einer hohen Basisfrequenz $f_0$ and großen Frequenzteilern ist es möglich, ähnliche Modulationsfrequenzen und gleichzeitig ein sicheres Verhindern eines Übersprechens zu erreichen.

Tabelle 2

| Kanäle | Frequenzteiler | kgV | Anzahl an Perioden |
|--------|----------------|-----|--------------------|
| 3 | 2, 3, 5 | 30 | 15, 10, 6 |
| 3 | 6, 10, 15 | 30 | 5, 3, 2 |
| 4 | 2, 3, 5, 7 | 210 | 105, 70, 42, 30 |
| 4 | 6, 10, 15, 21 | 210 | 35, 21, 14, 10 |
| 4 | 10, 14, 15, 21 | 210 | 21, 15, 14, 10 |
| 5 | 2, 3, 5, 7, 11 | 2310 | 1155, 770, 462, 330, 210 |
| 5 | 77, 55, 35, 33, 30 | 2310 | 30, 42, 66, 70, 77 |

Der Demodulationsalgorithmus 26, der die Lock-in-Amplitude und -Phase berechnet, kann auf viele äquivalente Weisen implementiert sein, bspw. durch Verwenden einer schnellen Fourier-Transformation, wenn die Datenerfassungszeitreihe pro Integrationszeit eine Anzahl von Abtastungen entsprechend einer Zweierpotenz enthält, oder durch Verwenden einer diskreten Fourier-Transformation, wobei beide bei der entsprechenden Modulationsfrequenz evaluiert sind. Alternativ kann insbesondere für eine kleine Anzahl an Kanälen die komplexe Amplitude $A_i$ für den Kanal i als eine diskrete Summe über der Zeitreihe $S_k$ berechnet werden:

$$A_i = \sum_{k=0}^{N_{Aqu}-1} s_k e^{\frac{2\pi n_i}{N_{Aqu}}k}$$

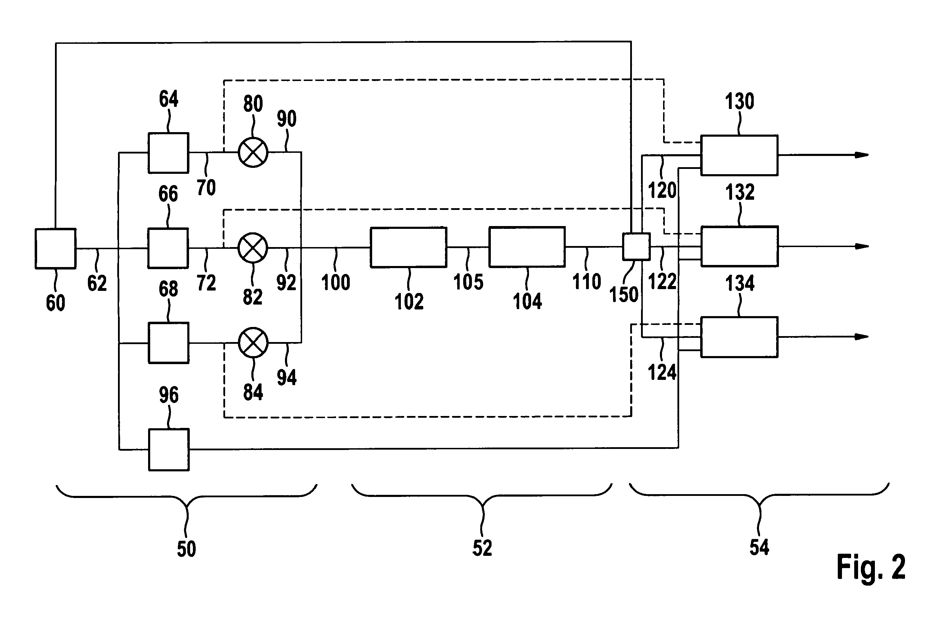

In Figur 2 ist als Ausführung des vorgestellten Verfahrens ein sogenanntes Lock-in-Verfahren dargestellt. Dieses Verfahren umfasst die Schritte:

Modulation 50,
Detektion 52 und
Demodulation 54.

Der als Modulation 50 bezeichnete Bereich dient zum Erzeugen einer Anzahl, in diesem Fall drei, an modulierten Anregungssignalen.
Hierzu ist ein Frequenzgenerator 60, bspw. ein Quarz, vorgesehen, der ein periodisches Signal 62 einer vorgebbaren Frequenz ausgibt. Dieses Signal wird einem ersten Frequenzteiler 64, einem zweiten Frequenzteiler 66 und einem dritten Frequenzteiler 68 zugeführt. Der erste Frequenzteiler 64 gibt ein erstes Modulationssignal 70, der zweite Frequenzteiler 66 ein zweites Modulationssignal 72 und der dritte Frequenzteiler 69 ein drittes Modulationssignal 74 aus. Diese drei Modulationssignale 70, 72 und 74 unterscheiden sich in ihrer Frequenz, wobei keine der Frequenzen ein ganzzahliges Vielfaches einer der anderen Frequenzen ist.
Mit dem ersten Modulationssignal 70 wird eine erste Quelle 80 angeregt, entsprechend wird mit dem zweiten Modulationssignal 72 eine zweite Quelle 82 und mit dem dritten Modulationssignal 74 eine dritte Quelle 84 angeregt. Somit ergeben sich ein erstes Anregungssignal 90, ein zweites Anregungssignal 92 und ein drittes Anregungssignal 94. Es handelt sich hierbei um modulierte Anregungssignale 90, 92, 94, wobei diese jeweils mit einem anderen Modulationssignal 70, 72 bzw. 74 moduliert sind.

Weiterhin zeigt die Darstellung einen vierten Frequenzteiler 96, der das kleinste gemeinsame Vielfache der drei Frequenzteiler 64, 66 und 68 darstellt. Mit diesem kann ein Integrationszeitraum für die später zu erfolgende Demodulation 54 festgelegt werden.

Da die Modulationssignale 70, 72 und 74 auf einen einzigen Frequenzgenerator 60 zurückgehen, sind diese zueinander synchronisiert. Grundsätzlich ist dies aber nicht zwingend erforderlich. Als Quellen 80, 82 und 84 können bspw. Lichtquellen verwendet werden, bspw. auch Laserlichtquellen. Diese werden mit dem jeweiligen Modulationssignal 70, 72 bzw. 74 angeregt und geben ein Signal aus, das mit dem jeweiligen Modulationssignal 70, 72 bzw. 74 moduliert ist. Es kann sich hierbei um eine Amplitudenmodulation handelt. D. h. das entsprechende Anregungssignal 90, 92 bzw. 94 hat eine durch die Quelle 80, 82, bzw. 84 vorgegebene Frequenz, wobei die Amplitude und somit die Intensität des Anregungssignals 90, 92 bzw. 94 durch die Frequenz des zugeordneten Modulationssignals 70, 72 bzw. 74 bestimmt ist. Anschließend werden die drei modulierten Anregungssignale 90, 92 und 94 in einem sogenannten Strahl-Kombinierer bzw. beam combiner zu einem Anregungsstrahl 100 kombiniert.

Die Frequenzen der Modulationssignale 70, 72, 74 können dicht beieinander liegen, so dass die Übertragung des Anregungsstrahls 100 nur eine geringe Bandbreite erfordert. Als Übertragungskanal wird bspw. eine Faser verwendet.

Der Anregungsstrahl 100 wird der Detektion 52 zugeführt. Diese Detektion 52 umfasst bspw. einen Detektorkopf 102 und eine Photodiode 104. Somit wird der Anregungsstrahl 100 üblicherweise über eine Faser in den Detektorkopf 102 eingekoppelt, es erfolgt dann die eigentliche Messung, bspw. die Bestrahlung einer Oberfläche. Der Detektorkopf 102 erfasst das Messsignal und koppelt dieses als Messstrahl 105 in eine Faser ein. Die Photodiode 104 erfasst den Messstrahl 105 und gibt diesen als Messsignal 110 an einen ADC 150 weiter.

Als Detektion 52 kann bspw. ein Verfahren zum berührungslosen Bestimmen einer Eigenschaft eines Gegenstands, bei dem ein Anregungsstrahl auf den Gegenstand projiziert wird und durch den Anregungsstrahl erzeugtes (Streu-)Licht über einen Strahlteiler, bspw. Streulichtfilter, räumlich selektiv erfasst wird, durchgeführt werden.

Mit diesem Verfahren kann eine Eigenschaft der Oberfläche des Gegenstands oder des Volumens, bspw. eine Eigenschaft einer Schicht des Gegenstands, bestimmt werden.

Als Streulichtfilter/Oberflächenreflexfilter kann ein Lochspiegel verwendet werden.

In einer weiteren Ausführung wird bei dem Verfahren die Eigenschaft basierend auf einer Transflexion bestimmt.

Bei dem als Transflexionsverfahren bezeichneten Messprinzip trifft die z. B. von einem Laser emittierte IR-Strahlung auf die zu untersuchende, vorab auf ein Substrat aufgetragene Farb- oder Lackschicht. Ein Teil der IR-Strahlung wird an der Phasengrenze Luft/Lack reflektiert. Die verbleibende IR-Strahlung durchdringt die Lackschicht, wird am Substrat reflektiert bzw. gestreut und durchdringt auf dem Weg an die Lackoberfläche ein zweites Mal das Lackvolumen, bevor sie an der Grenzfläche Lack/Luft wieder in die Atmosphäre austritt und auf den Empfänger trifft. Auf dem Weg durch die Lackschicht wird die IR-Strahlung durch Streuung und Absorption abgeschwächt.

Weiterhin kann vorgesehen sein, dass der Gegenstand mit einem Anregungsstrahl bei verschiedenen Wellenlängen abgetastet wird, wobei bei einer ersten Wellenlänge ein von der Eigenschaft abhängiges Nutzsignal und bei mindestens einer weiteren Wellenlänge ein von der Eigenschaft im wesentlichen unabhängiges Referenzsignal für eine Korrektur des Nutzsignals erfasst wird.

Weiterhin können bei dem Verfahren zwei Referenzsignale erfasst werden und mit den beiden Referenzsignalen eine Grundlinienkorrektur vorgenommen werden.

In diesem Fall kann die Grundlinie als Gerade im Spektralverlauf durch die beiden Referenzsignale bestimmt und das Nutzsignal mit einem Ordinatenwert der Geraden bei der Wellenlänge des Nutzsignals korrigiert werden.

Das Verfahren kann bspw. zur Härtungsprüfung eingesetzt werden.

Das Verfahren wird bspw. mit einer Messeinrichtung zum berührungslosen Bestimmen einer Eigenschaft einer Schicht durchgeführt, mit einer Kontrolleinheit zur Bereitstellung mindestens eines Anregungsstrahls und zum Auswerten von räumlich selektiv erfassten Streulicht und eine Detektionseinrichtung. Die Kontrolleinheit dient somit zur Durchführung der Modulation und der Demodulation.

In weiterer Ausgestaltung umfasst die Detektionseinrichtung einen Detektorkopf.

Der Detektorkopf weist in Ausgestaltung ein Gehäuse auf, in dem ein Strahlteiler, bspw. Streulichtfilter, angeordnet ist, wobei zusätzlich ein erster Anschluss zum Einkoppeln einer Faser für einen Anregungsstrahl und ein zweiter Anschluss zum Auskoppeln in eine Faser für einen Messstrahl vorgesehen ist. Weiterhin weist das Gehäuse ein optisches Medium, bspw. Fenster oder Linse, zum Durchleiten eines Anregungsstrahls und Streulicht, das räumlich selektiv von dem Streulichtfilter zu erfassen ist und auf den zweiten Anschluss zu führen ist, auf.

Dabei kann bzw. können der erste und/oder zweite Anschluss als Koppler ausgebildet sein.

Als Streulichtfilter kann ein Lochspiegel verwendet werden, der bspw. mit Metall, z.B. Gold, beschichtet ist.

Das Ergebnis der Detektion 52 ist das Messsignal 110, das zur Auswertung der Demodulation 54 zugeführt wird. Dabei ist in dieser Ausführung vorgesehen, dass das Messsignal 110 vor der Demodulation 54 zunächst mit dem Analog-/Digitalwandler (ADC) 150 in ein digitales Signal gewandelt wird. Dieser ADC 150 ist mit dem Frequenzgenerator 60 verbunden.

Das Messsignal 110 wird zunächst in drei Messsignale 120, 122 und 124 aufgespalten. Dieses Aufspalten kann rein programmtechnisch, in diesem Fall in dem ADC 150, durchgeführt werden. Bei der gezeigten Ausführung ergeben sich digitalisierte Messsignale 120, 122, 124. Die Auswertung kann bspw. durch eine Fourier-Transformation erfolgen.

Das erste Messsignal 120 wird einem ersten Lock-in-Modul 130, das zweite Messsignal 122 einem zweiten Lock-in-Modul 132 und das dritte Messsignal 124 einem dritten Lock-in-Modul 134 zugeführt.

In den Lock-in-Modulen 130, 132 und 134 findet jeweils eine Integration über einen Integrationszeitraum statt, der bspw. durch den vierten Frequenzteiler 96 vorgegeben wird. Das zur Integration jeweils erforderliche Modulationssignal 70, 72 bzw. 74 kann aus der Modulation 50 genommen werden (gestrichelte Linien).

So ist sichergestellt, dass bei der Demodulation 54 mit dem ersten Lock-in-Modul 130 das erste Modulationssignal 70 berücksichtigt wird und somit das Ergebnis auf das erste Anregungssignal 90 zurückgeht. Entsprechend wird in dem zweiten Lock-in-Modul 132 das zweite Modulationssignal 72 und in dem dritten Lock-in-Modul 134 das dritte Modulationssignal 74 berücksichtigt.

Die vorgestellte elektronische Einheit umfasst bei dieser Ausführung somit den Frequenzgenerator 60, die vier Frequenzteiler 64, 66, 68 und 96, die Quellen 80, 82 und 84 sowie die drei Lock-in-Module 130, 132 und 134.

Anstelle des vierten Frequenzteilers 96 kann die Information zu dem Integrationszeitraum auch aus den drei Modulationssignalen 70, 72 und 74 gewonnen werden. Alternativ kann auch bei der Demodulation 54 ein eigener Frequenzgenerator vorgesehen sein, der bspw. mit dem Frequenzgenerator 60 bei der Modulation 50 gekoppelt bzw. synchronisiert ist.

**Patentansprüche**

1.    Verfahren zum Bereitstellen einer Anzahl von modulierten Anregungssignalen, bei dem jedem der Anregungssignale ein periodisches Modulationssignal zugeordnet wird, wobei die Frequenzen der Modulationssignale unterschiedlich sind und keine der Frequenzen ein ganzzahliges Vielfaches einer der anderen Frequenzen ist, und bei dem mit jedem der Modulationssignale jeweils eine Quelle angeregt wird, so dass jede Quelle ein mit dem zugeordneten Modulationssignal moduliertes Anregungssignal ausgibt.

2.    Verfahren nach Anspruch 1, bei dem jeweils eine Amplitudenmodulation vorgenommen wird.

3.    Verfahren nach Anspruch 1, bei dem jeweils eine Frequenzmodulation vorgenommen wird.

4.    Verfahren nach einem der Ansprüche 1 bis 3, bei dem die Modulationssignale zueinander synchronisiert werden.

5.    Verfahren nach einem der Ansprüche 1 bis 4, bei dem mit den Modulationssignalen jeweils eine Lichtquelle angeregt wird.

6.    Verfahren nach Anspruch 5, bei dem als Lichtquellen Laserlichtquellen verwendet werden.

7.    Verfahren nach einem der Ansprüche 1 bis 6, bei dem die Anregungssignale zu einem Anregungsstrahl zusammengefasst werden.

8.    Verfahren nach einem der Ansprüche 1 bis 7, bei dem zusätzlich eine Detektion und eine Demodulation durchgeführt wird.

9.    Verfahren nach Anspruch 6, bei dem bei der Demodulation auf bei der Modulation verwendete Größen zurückgegriffen wird.

10.   Elektronische Einheit zum Modulieren einer Anzahl an Signalen, insbesondere zur Durchführung eines Verfahrens nach einem der Ansprüche 1 bis 9 mit einer Anordnung zum Bereitstellen einer Anzahl von Modulationssignalen und eine entsprechende Anzahl von Quellen, wobei die Frequenzen der Modulationssignale unterschiedlich sind und keine der Frequenzen ein ganzzahliges Vielfaches einer der anderen Frequenzen ist.

**11.** Elektronische Einheit nach Anspruch 10, bei der die Anordnung zum Bereitstellen einer Anzahl von Modulationssignalen einen Frequenzteiler umfasst.

**12.** Elektronische Einheit nach Anspruch 11, bei der die Quellen als Lichtquellen ausgebildet sind.

**13.** Elektronische Einheit nach einem der Ansprüche 10 bis 12, bei der eine Einrichtung zum Demodulieren vorgesehen ist.

**14.** Elektronische Einheit nach einem der Ansprüche 10 bis 13, bei der eine Einrichtung zur Detektion vorgesehen ist.

**15.** Elektronische Einheit nach Anspruch 14, bei die Einrichtung zur Detektion einen Detektorkopf umfasst.

Fig. 1

Fig. 2

Europäisches
Patentamt

European
Patent Office

Office européen
des brevets

## EUROPÄISCHER RECHERCHENBERICHT

**Nummer der Anmeldung**

EP 12 00 5574

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 6 512 384 B1 (LAGOWSKI JACEK [US] ET AL) 28. Januar 2003 (2003-01-28) * Spalte 8, Zeile 21 - Zeile 25; Abbildung 2 * * Spalte 7, Zeile 15 - Zeile 41 * ----- | 1,3-15 | INV. H03C1/00 H03C3/00 H03D9/00 G01J3/00 G01R31/00 G02F2/00 |
| X | US 2007/252988 A1 (LEVY JEREMY [US]) 1. November 2007 (2007-11-01) * Absatz [0041] - Absatz [0048]; Abbildung 8 * ----- | 1,2,4-7, 11,12 | |
| A | EP 0 429 081 A2 (RES CORP TECHNOLOGIES INC [US]) 29. Mai 1991 (1991-05-29) * Abbildung 3 * ----- | 1-15 | |
| A | US 8 064 740 B2 (SARTORIUS BERND [DE] ET AL) 22. November 2011 (2011-11-22) * Abbildung 3 * ----- | 1-15 | |

**RECHERCHIERTE SACHGEBIETE (IPC)**

H03C
H03D
G01J
G01R
G02F

Der vorliegende Recherchenbericht wurde für alle Patentansprüche erstellt

| Recherchenort | Abschlußdatum der Recherche | Prüfer |
|---|---|---|
| München | 4. Dezember 2012 | Schnabel, Florian |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
..............................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**      EP 12 00 5574

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

04-12-2012

| Im Recherchenbericht angeführtes Patentdokument | Datum der Veröffentlichung | Mitglied(er) der Patentfamilie | Datum der Veröffentlichung |
|---|---|---|---|
| US 6512384 B1 | 28-01-2003 | AU 8129101 A<br>DE 60123971 T2<br>EP 1311825 A1<br>JP 2004503100 A<br>TW I230262 B<br>US 6512384 B1 | 14-01-2002<br>08-03-2007<br>21-05-2003<br>29-01-2004<br>01-04-2005<br>28-01-2003 |
| US 2007252988 A1 | 01-11-2007 | US 2007252988 A1<br>WO 2006135389 A2 | 01-11-2007<br>21-12-2006 |
| EP 0429081 A2 | 29-05-1991 | CA 2030572 A1<br>EP 0429081 A2<br>FR 2656690 A1<br>GB 2238868 A<br>JP 3216526 A | 23-05-1991<br>29-05-1991<br>05-07-1991<br>12-06-1991<br>24-09-1991 |
| US 8064740 B2 | 22-11-2011 | DE 102006058395 A1<br>US 2010080505 A1<br>WO 2008067957 A2 | 19-06-2008<br>01-04-2010<br>12-06-2008 |

EPO FORM P0461

Für nähere Einzelheiten zu diesem Anhang : siehe Amtsblatt des Europäischen Patentamts, Nr.12/82